(19) Europäisches Patentamt
European Patent Office
Office européen des brevets

(11) EP 0 594 834 B1

(12) **FASCICULE DE BREVET EUROPEEN**

(45) Date de publication et mention de la délivrance du brevet:
**03.03.1999 Bulletin 1999/09**

(21) Numéro de dépôt: 93911722.2

(22) Date de dépôt: 18.05.1993

(51) Int Cl.⁶: **H03K 17/687**, H03K 3/356, G09G 3/28

(86) Numéro de dépôt international:
**PCT/CH93/00124**

(87) Numéro de publication internationale:
**WO 93/23926 (25.11.1993 Gazette 1993/28)**

(54) **CIRCUIT INTERMEDIAIRE ENTRE UN CIRCUIT LOGIQUE A BASSE TENSION ET UN ETAGE DE SORTIE A HAUTE TENSION REALISES DANS UNE TECHNOLOGIE CMOS STANDARD**

In Standard-CMOS-Technologie realisierte, zwischen einer Logikschaltung mit niedriger Versorgungsspannung und einer Ausgangsstufe mit hoher Versorgungsspannung, liegende Schaltung

INTERMEDIARY CIRCUIT BETWEEN A LOW-VOLTAGE LOGIC CIRCUIT AND A HIGH-VOLTAGE OUTPUT STAGE IN STANDARD CMOS TECHNOLOGY

(84) Etats contractants désignés:
**AT BE CH DE DK ES FR GB IE IT LI NL SE**

(30) Priorité: **18.05.1992 FR 9206030**

(43) Date de publication de la demande:
**04.05.1994 Bulletin 1994/18**

(73) Titulaire: **ECOLE POLYTECHNIQUE FEDERALE DE LAUSANNE**
**1015 Lausanne (CH)**

(72) Inventeurs:
• **DECLERQ, Michel**
**CH-1303 Penthaz (CH)**
• **SCHUBERT, Martin**
**CH-1020 Renens (CH)**

(74) Mandataire: **Nithardt, Roland**
**Cabinet Roland Nithardt,**
**Conseils en Propriété Industrielle S.A.,**
**Y-Parc Scientifique et Technologique,**
**Chemin de la Sallaz**
**1400 Yverdon-les-Bains (CH)**

(56) Documents cités:
WO-A-86/03632          DE-A- 3 733 046
GB-A- 2 060 300        US-A- 4 164 842
US-A- 4 952 825

• **NEC RESEARCH & DEVELOPMENT, no. 94, Juillet 1989, TOKYO, JP pages 29 - 35 M. NAKANO ET AL. 'Full - Complementary High - Voltage Driver ICs for Flat Display Panels'**
• **PATENT ABSTRACTS OF JAPAN vol. 006, no. 072 (E-105)7 Mai 1982 & JP,A,57 011 536 ( NEC CORP ) 21 January 1982**
• **PATENT ABSTRACTS OF JAPAN vol. 12, no. 115 (E-599)(2962) 12 Avril 1988 & JP,A,62 245 715 ( NEC CORP ) 27 October 1987**

## Description

La présente invention concerne un circuit intermédiaire connectable entre un circuit intégré logique à basse tension et un étage de sortie à haute tension pour la commande de transducteurs, d'écrans plasma et d'actionneurs électromécaniques, dans lequel ledit étage de sortie haute tension comporte deux transistors, respectivement à canal N et à canal P, réalisés selon une technologie CMOS standard, ledit circuit intermédiaire étant agencé pour former un translateur ou décaleur de niveau de tension couplé entre ledit circuit logique d'entrée basse tension et l'électrode de grille du transistor à canal P dudit étage de sortie haute tension auquel il fournit la tension de contrôle adéquate, fournie par l'un de deux blocs de base identiques du circuit intermédiaire.

Dans le contexte de la présente invention, on appelle "haute tension" toute tension plus élevée que la tension "nominale" ou "normale" d'utilisation d'une technologie, tolérances comprises. Cette tension "nominale" ou "normale" d'utilisation correspond à la tension d'alimentation normalement appliquée aux composants et/ou circuits MOS standards réalisés dans cette technologie, et que ceux-ci peuvent supporter sans dommage en régime continu ou transitoire. Cette tension normale est généralement égale ou inférieure à 5 V.

De façon générale, les capteurs et les actionneurs sont destinés à établir la communication entre les circuits de traitement du signal et leur environnement. Les capteurs fournissent à ces circuits des données extérieures. Les actionneurs transforment les signaux de faible puissance et de faible tension en actions extérieures telles que par exemple la commutation de relais dans un véhicule automobile etc. Au cours de ces dernières années, les circuits de puissance avec fonction intelligente, dits "Smart power electronics", se sont révélés particulièrement intéressants pour de multiples applications.

Afin de coupler des circuits logiques à basse tension basés sur une technologie standard de fabrication de semi-conducteurs oxyde-métal à symétrie complémentaire, dite "CMOS standard", avec des étages de sortie "CMOS" haute tension sur un même circuit intégré, et ceci à des coûts de production faibles, on a réussi à produire des transistors métal-oxyde à effet de champ. appelés par la suite MOSFETs à haute tension qui soient tout à fait compatibles avec des technologies dites basse tension standard. Ce résultat a pu être atteint par une combinaison nouvelle des couches technologiques existantes dans le procédé CMOS standard qui n'est pas modifié. Le fait de supporter des tensions élevées est dû à la création de zones tampon faiblement dopées entre le canal et le drain et à l'utilisation d'électrodes de champ et d'écrans de protection.

Les MOSFETs à haute tension qui en résultent ont la même tension de seuil $V_T$ que leurs correspondants de type basse tension, mais sont capables de supporter des tensions drain-source élevées $V_{DS}$ qui dépassent 75 V. Ces composants sont cependant limités à une tension $V_{GS}$ grille-source faible en raison de la faible épaisseur standard des oxydes de la grille, ce qui crée un problème pour la réalisation sûre et efficace d'un circuit intermédiaire du type mentionné ci-dessus destiné à être interposé entre un circuit logique basse tension et un étage de sortie haute tension.

La topologie des sorties-inverseurs à haute tension du type CMOS est similaire à la topologie classique des inverseurs CMOS dans lesquels la source et la masse du transistor à canal N sont connectées à la terre $V_{SS}$, la source et la masse du transistor à canal P sont connectées à la haute tension positive d'alimentation $V_{DDH}$ et les drains des deux transistors sont connectés ensemble à la sortie. Une différence essentielle apparaît toutefois pour commander les grilles avec un signal issu du circuit logique à basse tension. La grille du transistor MOSFET à canal N à haute tension appelé transistor NMOS-HT peut être facilement contrôlée par les niveaux de la logique basse tension $0/V_{DD}$, tandis que la grille du transistor MOSFET à canal P à haute tension appelé transistor PMOS-HT, nécessite un glissement de niveau pour pouvoir être actionné entre ($V_{DDH}$ - $V_{DD}$) et $V_{DDH}$ afin de respecter les conditions relatives à la tension entre la grille et la source $V_{GS}$.

Diverses publications antérieures décrivent des circuits décaleurs de tension, mais aucune ne remplit le but fixé par la présente invention et n'exploite les moyens de cette invention pour atteindre le but fixé.

Le circuit décrit par le brevet GB-A-2 060 300 a une fonction qui diffère totalement de celle prévue pour le circuit faisant l'objet de la présente demande. En effet, cette publication présente un circuit de type analogique destiné à remplir la fonction de "sense amplifier", c'est-à-dire destiné à être utilisé comme amplificateur de lecture dans des mémoires (col.2, lignes 78-80), où il amplifie des petites différences de potentiel analogiques appliquées entre ses deux entrées. La fonction de "sense amplifier" est citée dans chacune des six revendications de ce brevet (col.3, lignes 40-82). Le circuit objet de la présente invention est un circuit d'interface de type numérique (les signaux d'entrée et de sortie sont numériques), dont la fonction n'est pas d'amplifier, mais bien de reproduire, avec un décalage de tension adéquat, un signal de commande numérique appliqué à son entrée. En outre, les transistors utilisés dans le présent circuit sont du type haute tension réalisés dans une technologie CMOS basse tension standard, ce qui n'est pas le cas dans le brevet cité en référence.

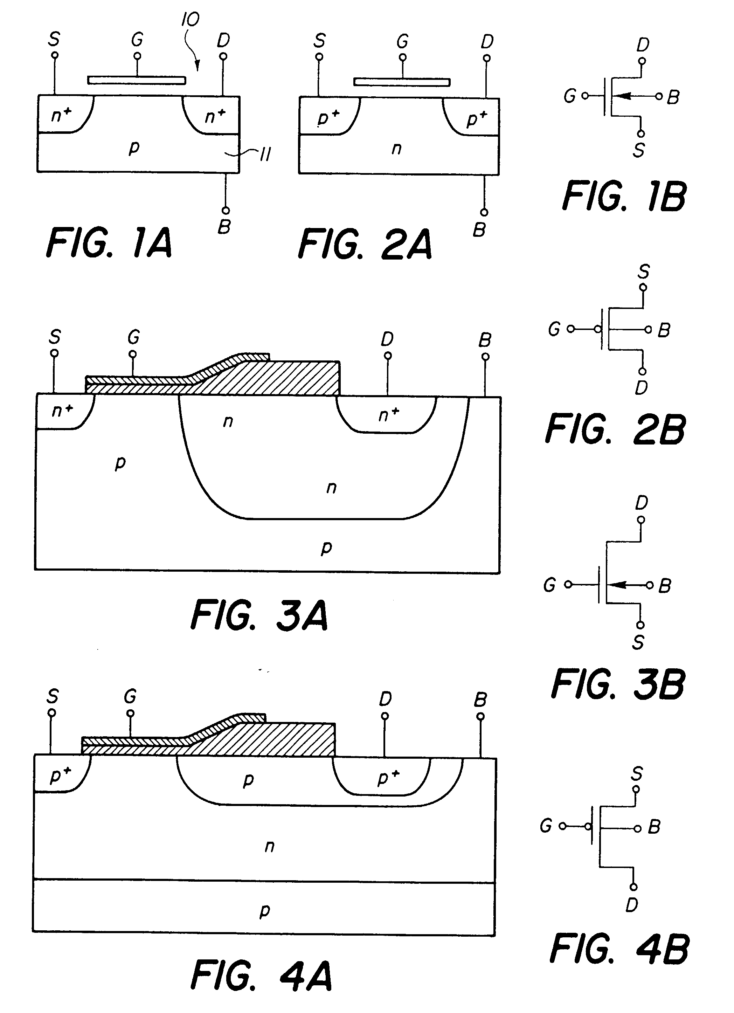

Le circuit intermédiaire décaleur de tension décrit par le brevet US-A-4,952,825 n'utilise pas une technologie CMOS basse tension standard. En particulier, les transistors MOS haute tension de type canal P sont dotés d'un oxyde de grille plus épais que les composants basse tension, ce qui autorise et exige des tensions de contrôle élevées, et change totalement les données du problème. Par ailleurs, la sortie du circuit de translation de la fig. 2A a pour rôle de produire un signal dont l'amplitude est égale à la dynamique totale de l'alimentation haute tension. Ceci illustre bien la fonction d'amplification de ce circuit.

La présente invention se propose de pallier ces différents inconvénients en réalisant un circuit du type mentionné précédemment pour commander un étage de sortie inverseur CMOS à haute tension par un circuit logique à faible tension, d'une manière originale, fiable et peu coûteuse, du fait qu'elle utilise des technologies connues et parfaitement maîtrisées. Ce circuit est en outre capable de s'adapter automatiquement à une très large gamme de tensions $V_{DDH}$.

Dans ce but, le circuit selon l'invention est caractérisé en ce que les deux blocs de base identiques forment des miroirs de tension, chaque miroir de tension étant agencé pour fournir, entre sa borne de sortie de tension et la tension d'entrée haute tension, une différence de potentiel d'amplitude égale mais de signe opposé à la différence de potentiel appliqué entre sa borne d'entrée et la masse, en ce que chaque miroir de tension comporte au moins un premier transistor basse tension à canal P et un deuxième transistor de type NMOS haute tension réalisé dans une technologie CMOS standard, le drain du premier transistor étant connecté au drain du deuxième transistor et à la grille du premier transistor, et fournissant la tension de sortie, la tension d'entrée ou son inverse de niveau basse tension étant connectée à la grille du deuxième transistor, et l'alimentation haute tension étant connectée à la source du premier transistor, ainsi qu'un troisième transistor à canal P dont la source et le drain sont connectés en parallèle respectivement avec la source et le drain dudit premier transistor à canal P, la source du deuxième transistor étant reliée à la masse, et en ce que lesdits deux miroirs de tension sont interconnectés entre eux de façon croisée, le drain du deuxième transistor du premier miroir de tension étant connecté à la grille du troisième transistor du deuxième miroir de tension et le drain du deuxième transistor du deuxième miroir de tension étant connecté à la grille du troisième transistor du premier miroir de tension.

Dans une variante de réalisation, le circuit peut comporter en outre une unité logique agencée pour éviter la conduction simultanée des transistors de l'étage de sortie.

La présente invention sera mieux comprise en référence à la description d'exemples de réalisation et des dessins annexés dans lequel :

les figures 1A, 2A, 3A et 4A illustrent des vues en coupe de différents transistors du type MOSFET et MOSFET à haute tension réalisés selon une technologie CMOS,

les figures 1B, 2B, 3B et 4B illustrent les symboles utilisés pour représenter les transistors illustrés en coupe par les figures précédentes,

la figure 5A représente une vue schématique illustrant le principe de l'invention,

la figure 5B représente un graphique des tensions en fonction du temps correspondant au fonctionnement du circuit représenté par la figure 5A,

la figure 6 représente une première forme de réalisation partielle d'un miroir de tension,

la figure 7 représente un miroir de tension utilisé dans le cadre de la présente invention,

la figure 8 illustre une première forme de réalisation du translateur de niveau de tension qui constitue le coeur du circuit intermédiaire entre la logique à basse tension et l'étape de sortie haute tension selon l'invention, et

la figure 9 représente une variante perfectionnée du circuit illustré par la figure 8.

En référence aux figures 1A et 1B, le transistor 10 du type N-MOSFET comporte un substrat 11 du type P et deux zones dopées N$^+$ correspondant respectivement à la source S et au drain D. La grille G est ménagée au-dessus du canal reliant les deux zones dopées N$^+$.

Le transistor de type P-MOSFET représenté par les figures 2A et 2B diffère du précédent en ce que le substrat P est remplacé par une cuvette N et les zones dopées N$^+$ sont remplacées par des zones dopées P$^+$.

Le transistor illustré par les figures 3A et 3B est du type N-MOSFET à haute tension utilisant une cuvette N comme zone tampon.

Le transistor représenté par les figures 4A et 4B diffère du précédent en ce qu'il est du type P et comporte une zone tampon de type P.

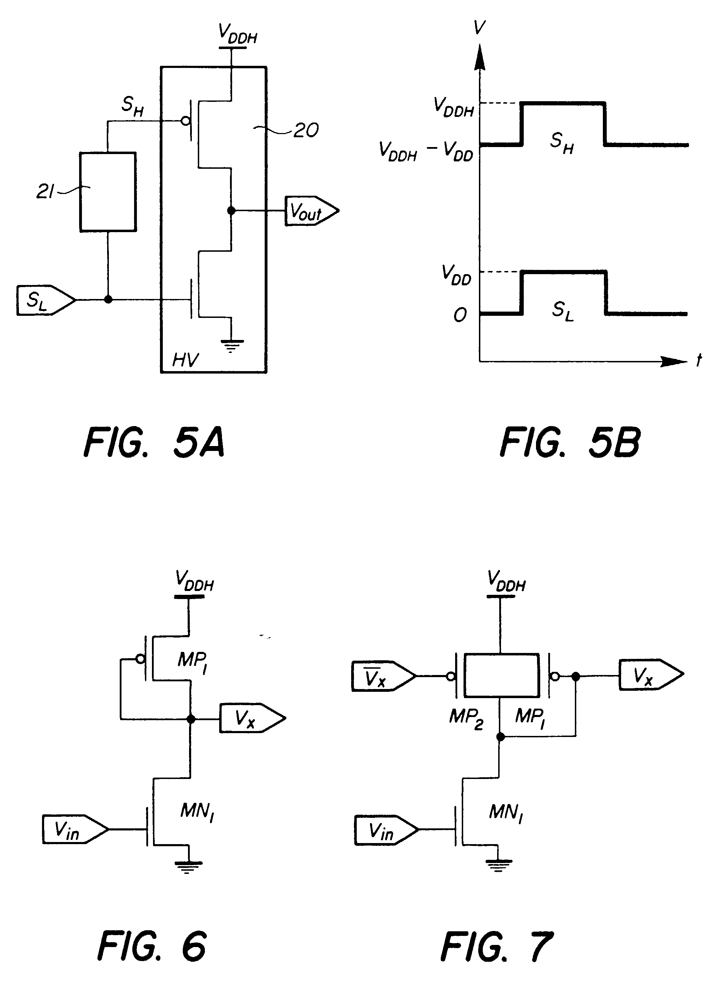

Les figures 5A et 5B illustrent un étage de sortie haute tension 20 qui est associé à un dispositif translateur de niveau de tension 21 monté entre une entrée basse tension $S_L$, dont la valeur se situe habituellement entre 0 et 5 V, et une sortie destinée à commander le transistor PMOS-HT et dont la valeur $S_H$ reproduit celle de l'entrée $S_L$ avec un décalage ($V_{DDH}$ - $V_{DD}$). Le niveau $V_{DD}$ se situe habituellement, mais non obligatoirement, à 5 V. Le niveau $V_{DDH}$ peut se situer à n'importe quelle valeur supérieure à $V_{DD}$ , typiquement entre 5 V et 75 V. Dans le cas où, par exemple, $V_{DDH}$ = 24 V et $V_{DD}$ = 5 V, $S_L$ varie de 0 à 5 V, et la sortie $S_H$ varie entre 19 et 24V.

En référence à la figure 6, le miroir de tension, sous sa forme partielle, comporte deux transistors respectivement du type P et N, à savoir les transistors MOS, respectivement MP1 et MN1. Le transistor MN1 est chargé par le transistor MP1 dont la grille est connectée au drain de ce même transistor. Le circuit de base de ce miroir de tension est monté entre une haute tension $V_{DDH}$ et la terre et contrôlé par une tension d'entrée $V_{IN}$. Il est destiné à fournir à la sortie une tension $V_X$ telle que $V_{DDH}$ - $V_X$ soit égale à $V_{IN}$. Lorsqu'ils sont rendus conducteurs, les transistors MN1 et MP1 fonctionnent normalement en régime saturé. Le transistor MN1 peut toutefois entrer dans la zone non saturée de ses caractéristiques pour des tensions $V_{DDH}$ de faible valeur.

En conséquence, lorsque les deux transistors fonctionnent en régime saturé, on peut écrire l'égalité suivante :

$$I = \frac{\beta_n}{2} (V_{GS,n} - V_{T,n})^2 = \frac{\beta_p}{2} ( \left| V_{GS,p} \right| - \left| V_{T,p} \right| )^2$$

dans laquelle :

I est l'intensité

$\beta n$ est un coefficient dépendant de la taille du transistor à canal N

$\beta p$ est un coefficient dépendant de la taille du transistor à canal P

$V_{GS,n}$ est la tension grille-source pour le transistor à canal N

$V_{GS,p}$ est la tension grille-source pour le transistor à canal P

$V_{T,p}$ est la tension de seuil du transistor à canal P

$V_{T,n}$ est la tension de seuil du transistor à canal N

ou :

$$I = \frac{\beta_n}{2} (V_{IN} - V_{T,n})^2 = \frac{\beta_p}{2} [(V_{DDH} - V_X) - \left| V_{T,p} \right| )]^2$$

et de ce fait :

$$V_{DDH} - V_X = \sqrt{\frac{\beta_n}{\beta_p}} (V_{IN} - V_{T,n} + \left| V_{T,p} \right| )]$$

ou

$$V_{DDH} - V_X = V_{IN} \text{ pour } \beta_n = \beta_p \text{ et } V_{T,n} = V_{T,p}$$

$V_{IN}$ étant limité à une alimentation basse tension $V_{DD}$, le transistor PMOS appelé MP1 est un composant à basse tension tandis que le transistor NMOS appelé MN1 supporte la part la plus importante de la chute de tension et doit être du type à haute tension.

Lorsque $V_{IN}$ est égale à $V_{DD}$, la tension de sortie $V_X$ est effectivement égale à $V_{DDH}$ - $V_{DD}$. D'autre part, lorsque $V_{IN}$ = 0, les deux transistors sont bloqués et la tension de sortie augmente et atteint la valeur ($V_{DDH}$ - I$V_{T,p}$I) toutefois sans atteindre la tension $V_{DDH}$.

La figure 7 illustre une réalisation du miroir de tension, dans laquelle un second transistor PMOS, à savoir le transistor MP2, est connecté en parallèle avec le premier transistor MP1 et peut être utilisé pour amener $V_X$ à la valeur $V_{DDH}$ lorsque $V_{IN}$ est au niveau 0 et aboutir ainsi à la réalisation idéale du miroir de tension. La tension de commande pour commuter ce composant supplémentaire est le complément de $V_X$ soit $\overline{V_X}$. Ce dispositif constitue la base d'un dispositif translateur de tension idéal pour le signal $V_{IN}$ et est utilisé dans le circuit intermédiaire translateur de niveau de tension décrit ci-dessous.

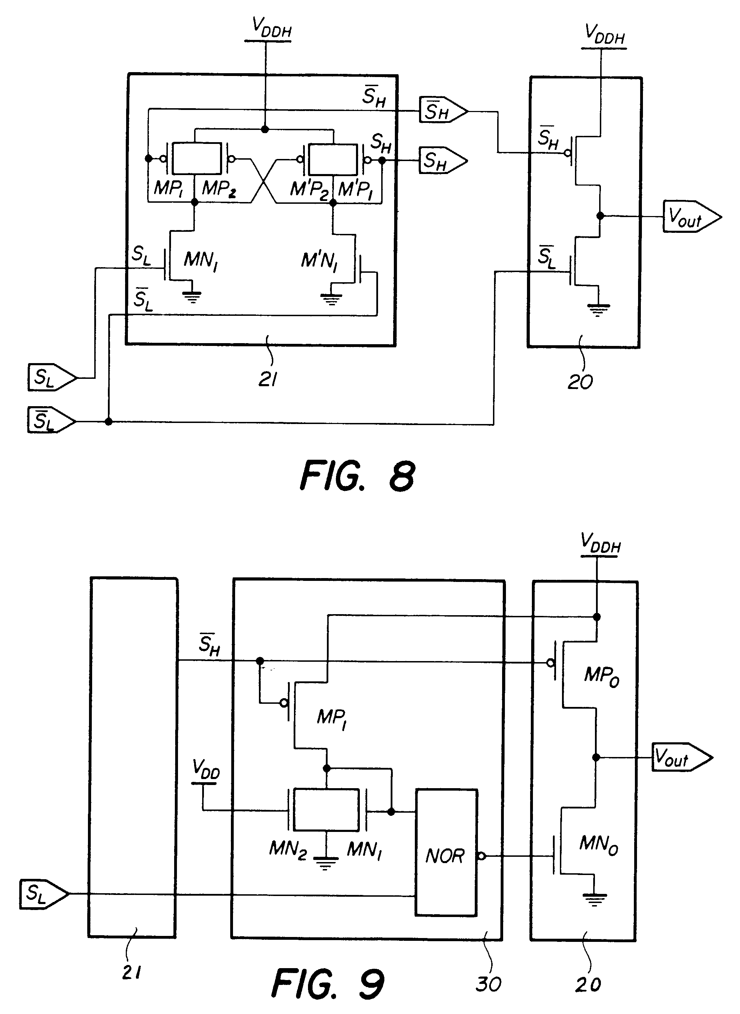

Le translateur de niveau de tension représenté par la figure 8 comporte deux miroirs de tension à couplage croisé pour constituer une bascule à haute tension commandée par les signaux d'entrée basse tension complémentaires $S_L$ et $\overline{S_L}$. Les signaux de sortie $S_H$ et $\overline{S_H}$ fournissent la translation requise de $V_{IN}$ avec un décalage complet de

EP 0 594 834 B1

$(V_{DDH} - V_{DD})$ à $V_{DDH}$ pour $S_L = V_{IN}$ entre 0 et $V_{DD}$.

Ce circuit intermédiaire de translation de niveau de tension présente la robustesse et la flexibilité requises pour son utilisation dans de nombreuses applications notamment comme circuit de commande de transducteurs, d'écrans plasma, de relais électromécaniques, de mécanismes d'asservissement ou similaires.

La conception de ce circuit translateur testé qui garantit pour le signal $V_X$ une dynamique complète d'amplitude $V_{DD}$ entre les valeurs $(V_{DDH} - V_{DD})$ et $V_{DDH}$ a été basée sur l'hypothèse que les transistors NMOS à haute tension MN1 et MN2 du circuit intermédiaire travaillent dans leurs zones de saturation lorsqu'ils sont commutés. En partant du fait que la chute de tension maximum aux bornes des transistors à canal P est $V_{DD}$, il est vérifié que cette condition de saturation des NMOS-HT est remplie pour $V_{DDH} \geq (2V_{DD} - V_T)$.

Pour des valeurs de $V_{DDH}$ inférieures à cette limite, MN1 et MN2 seraient commutés hors de leur zone de saturation.

Lorsqu'on considère le circuit miroir de tension illustré par la figure 6, les relations définissant l'intensité continue sont alors les suivantes :

$$I = \beta_n \left( (V_{GS,n} - V_{T,n})V_{DS,n} - \frac{V^2_{DS,n}}{2} \right) = \frac{\beta_p}{2} \left( |V_{GS,p}| - |V_{T,p}| \right)^2$$

ou

$$I = \beta_n \left( (V_{IN} - V_{T,n})V_x - \frac{V^2_x}{2} \right) = \frac{\beta_p}{2} \left[ (V_{DDH} - V_x) - |V_{T,p}| \right]^2$$

Dans le but d'une simplification, on part des hypothèses suivantes :

$$\beta_n = \beta_p \text{ et } V_{T,n} = |V_{T,p}| = V_T$$

Lorsque $V_{DDH}$ atteint la limite inférieure égale à $V_{DD}$ pour $V_{IN} = V_{DD}$, la relation ci-dessus donne :

$$V_X = 0,3 \, (V_{DD} - V_T)$$

De ce fait, l'amplitude maximum des variations des tensions $V_X$ et $\overline{V_X}$ entre leurs deux limites est légèrement inférieure à la pleine tension $V_{DD}$, mais largement suffisante pour rendre conducteurs les transistors MOS à canal P du circuit translateur de niveau de tension.

Le translateur de niveau de tension de la figure 8 fonctionnera de ce fait correctement pour une gamme très large de valeurs $V_{DDH}$ s'étendant d'une alimentation basse tension $V_{DD}$ jusqu'à une tension maximale autorisée par les caractéristiques de court-circuit des composants MOS à haute tension.

Au moment de l'enclenchement de la source d'alimentation en puissance, le comportement du circuit est principalement déterminé par les capacités parasites associées aux dispositifs actifs.

Des simulations ont montré que la capacité grille-source $C_{GS}$ est dominante et maintient la tension $V_X$ et $\overline{V_X}$ près de $V_{DDH}$, ainsi que la tension $V_{GS}$ de tous les composants MOS à l'intérieur de leurs domaines de sécurité.

Afin de réduire la puissance statique du circuit translateur de niveau de tension, il est préférable d'utiliser des composants de faible dimension. La vitesse de commutation qui est habituellement non critique dans la plupart des applications de l'automatisme doit se situer dans la gamme des micro-secondes.

La figure 9 illustre une forme de réalisation perfectionnée du circuit translateur de niveau de tension associé à une logique qui permet une réduction significative de la dissipation de la puissance transitoire pendant la phase de commutation. Pendant les situations transitoires de commutation, les deux transistors respectivement NMOS et PMOS à haute tension de l'étage de sortie peuvent se trouver momentanément et simultanément dans un état conducteur. Cette situation est la conséquence de différents délais dans la transmission des signaux de commande $S_L$ et $S_H$. Lorsqu'il se produit une telle situation transitoire, on obtient un chemin conducteur entre l'alimentation à la tension $V_{DDH}$ et la terre, ce qui engendre des pics d'intensité élevés dans les étages de puissance de sortie. Ces situations transitoires peuvent facilement être évitées par l'adjonction d'un circuit logique 30 interdisant la superposition, c'est-à-dire empêchant que les transistors de l'étage de sortie 20 soient simultanément conducteurs. Ce circuit logique est constitué d'un transistor MOS haute tension à canal P, de 2 transistors MOS à canal N et d'une porte logique NOR interconnectés entre eux selon le schéma de la figure 9. Ce circuit supplémentaire est principalement utilisé pour des transistors de puissance, dans des applications nécessitant une puissance élevée.

## Revendications

1. Circuit intermédiaire (21, 30) connectable entre un circuit intégré logique à basse tension et un étage de sortie à haute tension pour la commande de transducteurs, d'écrans plasma et d'actionneurs électromécaniques, dans lequel ledit étage de sortie haute tension (20) comporte deux transistors, respectivement à canal N ($MN_0$) et à canal P ($MP_0$), réalisés selon une technologie CMOS standard, ledit circuit intermédiaire (21) étant agencé pour former un translateur ou décaleur de niveau de tension couplé entre ledit circuit logique d'entrée basse tension et l'électrode de grille du transistor à canal P ($MP_0$) dudit étage de sortie haute tension auquel il fournit la tension de contrôle adéquate, ledit circuit intermédiaire comportant deux blocs de base identiques, dont l'un fournit ladite tension de contrôle adéquate, et caractérisé en ce que les deux blocs de base identiques forment des miroirs de tension, chaque miroir de tension étant agencé pour fournir, entre sa borne de sortie de tension ($V_X$) et la tension d'entrée haute tension ($V_{DDH}$), une différence de potentiel d'amplitude égale mais de signe opposé à la différence de potentiel appliqué entre sa borne d'entrée et la masse, en ce que chaque miroir de tension comporte au moins un premier transistor basse tension à canal P ($MP_1$, $M'P_1$) et un deuxième transistor ($MN_1$, $M'N_1$), de type NMOS haute tension réalisé dans une technologie CMOS standard, le drain du premier transistor ($MP_1$, $M'P_1$) étant connecté au drain du deuxième transistor ($MN_1$, $M'N_1$)) et à la grille du premier transistor ($MP_1$, $M'P_1$), et fournissant la tension de sortie ($V_X$), la tension d'entrée ($V_{IN}$) ou son inverse ($\overline{V_{IN}}$) de niveau basse tension étant connectée à la grille du deuxième transistor ($MN_1$, $M'N_1$), et l'alimentation haute tension ($V_{DDH}$) étant connectée à la source du premier transistor ($MP_1$, $M'P_1$), ainsi qu'un troisième transistor à canal P ($MP_2$, $M'P_2$) dont la source et le drain sont connectés en parallèle respectivement avec la source et le drain dudit premier transistor à canal P ($MP_1$, $M'P_1$), la source du deuxième transistor ($MN_1$, $M'N_1$)) étant reliée à la masse ($V_{SS}$), et en ce que lesdits deux miroirs de tension sont interconnectés entre eux de façon croisée, le drain du deuxième transistor ($MN_1$) du premier miroir de tension étant connecté à la grille du troisième transistor ($M'P_2$) du deuxième miroir de tension et le drain du deuxième transistor ($M'N_1$) du deuxième miroir de tension étant connecté à la grille du troisième transistor ($MP_2$) du premier miroir de tension.

2. Circuit selon la revendication 1, caractérisé en ce qu'il comporte en outre une unité logique (30) agencée pour éviter la conduction simultanée des transistors ($MP_0$, $MN_0$) de l'étage de sortie (20).

## Patentansprüche

1. Zwischenschaltung (21,30), die zwischen einer integrierten Logikschaltung mit niedriger Spannung sowie einer Ausgangsstufe mit hoher Spannung für die Steuerung von Wandlern, Plasmaschirmen und elektromechanischen Schaltern anschließbar ist, wobei die besagte Ausgangsstufe mit hoher Spannung (20) jeweils bei einem Kanal N ($MN_0$) und bei einem Kanal P ($MP_0$) zwei Transistoren aufweist, die in einer Standard-CMOS-Technologie realisiert sind, wobei die besagte Zwischenschaltung (21) so angeordnet ist, daß sie einen Übertrager oder einen Spannungsniveauregler bildet, der zwischen der besagten Eingangslogikschaltung mit niedriger Spannung, und der Gitterelektrode des Transistors bei dem Kanal P ($MP_0$) der besagten Ausgangsstufe mit hoher Spannung geschaltet ist, der die passende Steuerspannung liefert, wobei die besagte Zwischenschaltung zwei identische Basisblöcke aufweist, von denen einer die passende Steuerspannung liefert,

   **dadurch gekennzeichnet,** daß
   die beiden identischen Basisblöcke Spannungsspiegel bilden, wobei jeder Spannungsspiegel so angeordnet ist, daß er zwischen seiner Ausgangsspannungsklemme ($V_X$) und seiner eine hohe Spannung aufweisenden Eingangsspannung ($V_{DDH}$) ein Amplitudenpotential mit entgegengesetztem Vorzeichen gegenüber der Potentialdifferenz aufweist, die zwischen seiner Eingangsklemme und der Masse angewandt wird, wobei jeder Spannungsspiegel mindestens einen ersten Transistor mit niedriger Spannung bei dem Kanal P ($MP_1$,$M'P_1$) enthält, sowie einen zweiten Transistor ($MN_1$,$M'N_1$) in NMOS-Bauart, der in einer Standard-CMOS-Technologie realisiert ist, wobei die Drain-Elektrode des ersten Transistors ($MP_1$,$M'P_1$) mit der Drain-Elektrode des zweiten Transistors ($MN_1$,$M'N_1$), sowie mit dem Gitter des ersten Transistors ($MP_1$,$M'P_1$) verbunden ist, und die Ausgangsspannung ($V_X$), die Eingangsspannung ($V_{IN}$) oder deren Kehrwert ($\overline{V_{IN}}$) der niedrigen Spannung liefert, die mit dem Gitter des zweiten Transistors ($MN_1$,$M'N_1$) verbunden ist, und die Zufuhr hoher Spannung ($V_{DDH}$) mit der Quelle des ersten Transistors ($MP_1$,$M'P_1$) verbunden ist, und daß die Quelle und die Drain-Elektrode eines dritten Transistor bei dem Kanal P ($MP_2$,$M'P_2$) jeweils parallel mit der Quelle und der Drain-Elektrode des besagten ersten Transistors bei Kanal P ($MP_1$,$M'P_1$) verbunden sind, daß die Quelle des zweiten Transistors ($MN_1$,$M'N_1$) mit der Masse

(Vss) verbunden ist, und daß die besagten zwei Spannungsspiegel kreuzweise miteinander verbunden sind, wobei die Drain-Elektrode des zweiten Transistors ($MN_1$) des ersten Spannungsspiegels mit dem Gitter des dritten Transistors ($M'P_2$) des zweiten Spannungsspiegels, und der Drain-Elektrode des zweiten Transistors ($M'N_1$) des zweiten Spannungsspiegels verbunden ist, der mit dem Gitter des dritten Transistors ($MP_2$) des ersten Spannungsspiegels verbunden ist.

2. Schaltung nach Patentanspruch 1,
   **dadurch gekennzeichnet,** daß
   sie unter anderem eine Logikeinheit (30) enthält, die so angeordnet ist, daß sie die gleichzeitige Leitfähigkeit der Transistoren ($MP_0$,$MN_0$) der Ausgangsstufe (20) vermeidet.

**Claims**

1. An intermediary circuit (21, 30) connectable between a low-voltage logic integrated circuit and a high-voltage output stage for the control of transducers, plasma screens and electromechanical actuators, in which the said high-voltage output stage (20) comprises two transistors, respectively an N-channel transistor ($MN_0$) and a P-channel transistor ($MP_0$); produced in standard CMOS technology, the said intermediary circuit (21) being designed to form a voltage level converter or shifter coupled between the said low-voltage input logic circuit and the gate electrode of the P-channel transistor ($MP_0$) of the said high-voltage output stage to which it supplies the adequate control voltage, the said intermediary circuit comprising two identical basic units, the one of which supplies the said adequate control voltage,
   **and characterised in that** the two identical basic units form voltage mirrors, each voltage mirror being designed to supply, between its voltage output terminal ($V_X$) and the high-voltage input voltage ($V_{DDH}$), an amplitude potential difference which is equal to but of the sign opposite to the potential difference applied between its input terminal and the earth,
   **and in that** each voltage mirror comprises at least a first P-channel low-voltage transistor ($MP_1$, $M'P_1$) and a second NMOS-type high-voltage transistor ($MN_1$, $M'N_1$) made in standard CMOS technology, the drain of the first transistor ($MP_1$, $M'P_1$) being connected to the drain of the second transistor ($MN_1$, $M'N_1$) and to the gate of the first transistor ($MP_1$, $M'P_1$), and supplying the output voltage ($V_X$), the input voltage ($V_{IN}$) or its low-voltage level reciprocal ($V_{IN}$) voltage being connected to the gate of the second transistor ($MN_1$, $M'N_1$) and the high-voltage supply ($V_{DDH}$) being connected to the source of the first transistor ($MP_1$, $M'P_1$), and also a third P-channel transistor ($MP_2$, $M'P_2$), the source and the drain of which are connected in parallel respectively with the source and the drain of the said first P-channel transistor ($MP_1$, $M'P_1$), the source of the second transistor ($MN_1$, $M'N_1$) being connected to the earth ($V_{SS}$),
   **and in that** the said two voltage mirrors are interconnected in a crossed manner, the drain of the second transistor ($MN_1$) of the first voltage mirror being connected to the gate of the third transistor ($M'P_2$) of the second voltage mirror and the drain of the second transistor ($M'N_1$) of the second voltage mirror being connected to the gate of the third transistor ($MP_2$) of the first voltage mirror.

2. A circuit according to Claim 1,
   **characterised in that** it also comprises a logic unit (30) designed to avoid the simultaneous conduction of the transistors ($MP_0$, $MN_0$) of the output stage (20)

FIG. 1A

FIG. 2A

FIG. 1B

FIG. 3A

FIG. 2B

FIG. 3B

FIG. 4A

FIG. 4B

EP 0 594 834 B1

FIG. 5A

FIG. 5B

FIG. 6

FIG. 7

FIG. 8

FIG. 9